# EUROPEAN PATENT SPECIFICATION

(11) **EP 1 399 267 B1**
(45) Date of publication and mention of the grant of the patent: **03.11.2010**
(21) Application number: 02739639.9
(22) Date of filing: 31.05.2002
(51) Int. Cl.: B05C 11/10, H01L 21/00, H05K 13/04, B41J 2/045, B41J 2/05, B41J 3/54, B41J 3/407

(54) **MICRODEPOSITION APPARATUS**
MIKROABSCHEIDUNGSVORRICHTUNG
APPAREIL DE MICRO-DEPOT

(30) Priority: 01.06.2001 US 295100 P; 01.06.2001 US 295118 P
(43) Date of publication of application: 24.03.2004
(73) Proprietor: ULVAC, INC., Chigasaki Kanagawa 253-8543 (JP)
(72) Inventor: EDWARDS, Charles, O., Pleasanton, CA 94566 (US); ALBERTALLI, David, San Jose, CA 95117 (US); MIDDLETON, James, Brentwood, CA 94513 (US); BRUNER, Scott R., San Jose, CA 95118 (US); BIELICH, Howard, Walter, Brentwood, CA 94513 (US); GRATCHEV, Oleg, Pleasanton, CA 94588 (US)
(74) Representative: Somnier, Jean-Louis
(86) International application number: PCT/US2002/017519
(87) International publication number: WO 2002/098574

(56) References cited:
- GB-A- 2 350 321
- US-A- 5 498 444
- US-A- 5 505 777
- US-A- 5 681 757
- US-A- 5 707 684
- US-A- 5 711 989
- US-A- 5 711 989
- US-A- 5 932 012
- US-A- 5 935 375
- US-A- 6 007 631
- US-A- 6 007 631
- US-A- 6 132 809

## Description

### CROSS-REFERENCE TO RELATED APPLICATIONS

This application claims the benefit of United States Provisional Patent Application Serial No. 60/295,118, entitled "Formation of Microstructures Using Piezo Deposition of Liquid Onto Substrate," filed June 1, 2001, and United States Provisional Application Serial No. 60/295,100, entitled Formation Of Printed Circuit Board Structures Using Piezo Deposition Of Liquid Onto Substrate, filed June 1, 2001.

### DISCUSSION OF THE INVENTION

The present invention relates to methods and systems for forming microstructures on substrates and, more specifically, to methods and systems for performing piezoelectric microdeposition (PMD) of fluid manufacturing materials.

Manufacturers have developed various techniques for creating microstructures on substrates such as light-emitting diode (LED) display devices, liquid crystal display (LCD) devices, printed circuit boards (PCBs) and the like. Most of these manufacturing techniques are relatively expensive to implement and require large volumes of throughput to be economically feasible.

One technique for forming microstructures on a substrate includes screening. During screening, a fine mesh screen is positioned on the substrate and the fluid material is deposited through the screen and onto the substrate in a pattern dictated by the screen. One problem with screening is that it requires contact between the screen and substrate and also between the screen and the fluid material, thereby resulting in contamination of the substrate and the fluid material. While this technique is suitable for forming some structures, many manufacturing processes must be conducted without contamination in order for the resulting structures to be operational. Thus, screening is not a viable option for the manufacture of certain microstructures. By way of examples, and not limitations, microstructures that require a clean room environment and cannot tolerate contamination of the substrate or the fluid material are that of polymer light-emitting diode (PLED) display devices and PCBs.

In recent years, it has been discovered that certain polymeric substances can be used in diodes to generate visible light of different wavelengths. Using such polymers, display devices having pixels with sub-components of red, green, and blue can be created. PLED fluid materials are particularly desirable because they enable full-spectrum color displays and require very little power to emit a substantial amount of light.

It is expected that PLED displays will be used in the future for various applications, including televisions, computer monitors, PDAs, other handheld computing devices, cellular phones, and the like. It is also expected that PLED technology will be used for manufacturing light-emitting panels that can be used to provide ambient lighting for office, storage, and living spaces.

One obstacle to the widespread use of PLED display devices is the difficulty that has been experienced in manufacturing PLED display devices using conventional manufacturing techniques. For instance, as mentioned above, PLEDs cannot be manufactured using screen printing because the polymers are very sensitive to contamination.

Another technique used to manufacture microstructures on substrates for LED, LCD, and PCB products is photolithography. Manufacturing processes using photolithography generally involve the deposition of a photoresist material onto a substrate. The photoresist material is then cured by exposure to light. Typically a patterned mask is used to selectively apply light to the photoresist material, thereby curing certain portions of the photoresist layer, while leaving other portions uncured. The uncured portions are then removed from the substrate, which results in the underlying surface of the substrate being exposed through the photoresist layer, with the cured portions of the photoresist layer forming a mask that remains on the substrate. Another material is then deposited onto the substrate through the opened pattern on the photoresist layer, followed by the removal of the cured portion of the photoresist layer.

While photolithography has been successfully used to manufacture many microstructures such as, for example, traces on circuit board, this process can also contaminate the substrate and the material formed on the substrate. Therefore, photolithography is not compatible with the manufacture of contact-sensitive structures such as PLED displays and PCBs, for example, as the photoresist would contaminate the manufacturing materials. In addition, photolithography involves multiple steps for applying and processing the photoresist material, such that the cost can be prohibitive when relatively small quantities of structures are to be formed.

Other conventional techniques, such as spin coating, have been used to form other microstructures. Spin coating involves rotating a substrate while depositing fluid material at the center of the substrate. The rotational motion of the substrate causes the fluid material to spread evenly across the surface of the substrate. Spin coating, however, can be an expensive process, as a large majority of the fluid material does not remain on the substrate, but instead is wasted during the spin coating process or is removed by photolithography or laser oblation, thus requiring additional steps. ,

In contrast to conventional manufacturing processes for forming microstructures, the PMD processes of the invention are used to deposit droplets of fluid manufacturing materials on substrates without contamination of the substrates or the fluid manufacturing materials. Accordingly, the PMD processes of invention are particularly useful in clean room environments where contamination is to be avoided such as, for example, when manufacturing PLED display devices or PCBs.

The PMD methods and systems of the invention generally incorporate the use of a PMD tool, which includes a head to deposit fluid manufacturing materials on a substrate and a nozzle assembly including multiple independent nozzles. The PMD head is coupled with computer numerically controlled system for patterning, i.e., precisely depositing droplets of the fluid manufacturing material onto predetermined locations of the substrate and for individually controlling each of the nozzles. In general, the PMD head is configured to provide a high degree of precision and accuracy when used in combination with the various techniques and methods of the invention for forming microstructures on substrates.

Concerning precision and accuracy, the relative position between a substrate and the PMD head can be selected and controlled using an alignment component of the PMD system configured to identify fiducial markings on the substrate and to align the substrate with the PMD head. To increase the precision of the PMD systems, a drop diagnostics assembly identifies and analyzes the firing characteristics of the individual nozzles and the characteristics of the droplets discharged from the nozzles. The PMD systems of the invention are specifically configured to individually control the firing characteristics of the nozzles and to compensate for any deviation between the nozzles of the PMD head. Further, the PMD systems include a movable stage with a vacuum chuck configured to securely hold the substrate in a position relative to the PMD head. The stage includes plates configured to move the substrate, with respect to the PMD head, along the X axis and the Y axis of an X-Y horizontal plane. In other embodiments, the PMD head is configured to move relative to the substrate. For example, the PMD head can be mounted on a turret configured to rotate and the PMD head can also be mounted on a linear air bearing assembly configured to move the PMD head along a horizontal plane. US 6132809 and US 5932012 disclose dispensing apparatus and methods.

Depending on the nature of the fluid materials used and the structures to be formed, some or all the features described herein can be used in combination with the basic process of the invention for depositing fluid materials on a substrate with a PMD head. It has been found that manufacturing processes can be simplified and made less expensive using the PMD techniques of the invention, such as, for example, by making economically feasible the manufacture of smaller quantities. The PMD systems and processes of the invention also generally enable microstructures to be formed on substrates with a high degree of precision.

These and other objects and features of the present invention will become more fully apparent from the following description and appended claims, or may be learned by the practice of the invention as set forth hereinafter.

### BRIEF DESCRIPTION OF THE DRAWINGS

To further clarify the above and other advantages and features of the present invention, a more particular description of the invention will be rendered by reference to specific embodiments thereof which are illustrated in the appended drawings. It is appreciated that these drawings depict only typical embodiments of the invention and are therefore not to be considered limiting of its scope. The invention will be described and explained with additional specificity and detail through the use of the accompanying drawings in which:

Figure 1 illustrates a perspective view of one embodiment of the PMD system of the invention;

Figure 2 illustrates a side view of the PMD system of Figure 1;

Figure 3 illustrates a front view of the PMD system of Figure 1;

Figure 4 illustrates a top view of the PMD system of Figure 1;

Figure 5 illustrates a perspective view of one embodiment of a mounting bracket configured for coupling a PMD head to a PMD head support in the PMD system of Figure 1;

Figure 6 illustrates a side view of the mounting bracket of Figure 5 connected with a PMD head support that includes tubing of the fluid manufacturing supply system and a solvent supply system;

Figure 7 illustrates a side view of the mounting bracket and PMD head support of Figure 6 in which a PMD head has been mounted onto the mounting bracket and in which the tubing has been connected to the PMD head;

Figure 8 illustrates one embodiment of the PMD system of the invention that includes a computer configured for controlling the PMD system and components;

Figure 9 illustrates the mounting bracket, PMD head, and PMD head support of Figure 7 in which the mounting bracket and PMD head have been rotated on the PMD head support by 90°;

Figure 10 illustrates a capping station of the PMD system that includes a tray, an extendable support, and a soaking reservoir;

Figure 11 illustrates a front view of a docking station configured for mounting a PMD head during nonuse and for mounting a supply of the fluid manufacturing material in a pressure sensitive and pressure controllable working bag;

Figure 12 illustrates a side view of the docking station of Figure 11;

Figure 13 illustrates a front view of the docking station of Figure 11 with a PMD head mounted on the docking station;

Figure 14 illustrates one embodiment of a PMD head support comprising a linear air bearing assembly; and

Figure 15 illustrates one embodiment of a configuration of the PMD system that includes a plurality of PMD head supports mounted on linear air bearing assemblies.

### DETAILED DESCRIPTION OF THE PREFERRED EMBODIMENTS

The present invention is directed to Piezoelectric Micro Deposition (PMD) of fluid manufacturing materials on substrates in controlled quantities and placements to manufacture or create microstructures.

The terms "fluid manufacturing material" and "fluid material" as defined herein, are broadly construed to include any material that can assume a low viscosity form and which is suitable for being deposited from a PMD head onto a substrate for forming a microstructure. Fluid manufacturing materials may include, but are not limited to, light-emitting polymers (LEPs), which can be used to form polymer light-emitting diode display devices (PLEDs, and PolyLEDs). Fluid manufacturing materials may also include plastics, metals, waxes, solders, solder pastes, biomedical products, acids, photoresists, solvents, adhesives and epoxies. The term "fluid manufacturing material" is interchangeably referred to herein as "fluid material."

The term "deposition" as defined herein, generally refers to the process of depositing individual droplets of fluid materials on substrates. The terms "jet," "discharge," "pattern," and "deposit" are used interchangeably herein with specific reference the deposition of the fluid material from a PMD head. The terms "droplet" and "drop" are also used interchangeably.

The term "substrate," as defined herein, is broadly construed to include any material having a surface that is suitable for receiving a fluid material during a PMD process. Substrates include, but are not limited to, glass plates, pipettes, silicon wafers, ceramic tiles, rigid and flexible plastic and metal sheets and rolls. In certain embodiments, a deposited fluid material itself may form a substrate, inasmuch as they also comprise surfaces suitable for receiving a fluid material during a PMD process, such as, for example, when forming three-dimensional microstructures.

The term "microstructures," as defined herein, generally refers to structures formed with a high degree of precision, and that are sized to fit on a substrate. Inasmuch as the sizes of different substrates may vary, the term "microstructures" should not be construed to be limited to any particular size and can be used interchangeably with the term "structure". Microstructures may include a single droplet of a fluid material, any combination of droplets, or any structure formed by depositing the droplet(s) on a substrate, such as a two-dimensional layer, a three-dimensional architecture, and any other desired structure.

The PMD systems of the invention perform PMD processes by depositing fluid materials onto substrates according to user-defined computer-executable instructions. The term "computer-executable instructions," which is also referred to herein as "program modules" or "modules," generally includes routines, programs, objects, components, data structures, or the like that implement particular abstract data types or perform particular tasks such as, but not limited to, executing computer numerical controls for implementing the PMD processes of the invention. Program modules may be stored on any computer-readable media, including, but not limited to RAM, ROM, EEPROM, CD-ROM or other optical disk storage, magnetic disk storage or other magnetic storage devices, or any other medium capable of storing instructions or data structures and capable of being accessed by a general purpose or special purpose computer.

According to the invention, an ink jet head can deposit fluid manufacturing materials in manufacturing environments to form any of a wide variety of structures by patterning fluid manufacturing materials on a substrate according to the PMD processes of the invention, as best described in contemporaneously filed PCT Patent Application No. ______, filed May 31, 2002, entitled Temperature Controlled Vacuum Chuck; PCT Patent Application No. ______, filed May 31, 2002, entitled Industrial Microdeposition System For Polymer Light Emitting Diode Displays, Printed Circuit Boards And The Like; PCT Patent Application No. ______, filed May 31, 2002, entitled Interchangeable Microdeposition Head Apparatus And Method; PCT Patent Application No. ______, filed May 31, 2002, entitled Waveform Generator For Microdeposition Control System; PCT Patent Application No. ______, filed May 31, 2002, entitled Over-Clocking In A Microdeposition Control System To Improve Resolution; PCT Patent Application No. ______, filed May 31, 2002, entitled Formation Of Printed Circuit Board Structures Using Piezo Microdeposition; and PCT Patent Application No. ______, filed May 31, 2002, entitled Apparatus For Microdeposition Of Multiple Fluid Materials; each of which is incorporated herein by reference. Many structures can be manufactured according to the invention less expensively, more efficiently, and more accurately than the same structures manufactured using conventional techniques. Other structures that can be manufactured using PMD processes cannot be manufactured in conventional ways. Moreover, the PMD processes of the invention are compatible with clean room environments and with fluid manufacturing materials that cannot be contaminated during or after the manufacturing processes.

According to one embodiment, the PMD systems of the invention generally includes a stage, a vacuum chuck, a PMD head, a PMD head support, an alignment component, a fluid material supply system, a drop diagnostics assembly, a maintenance station, a capping station, a docking station, and a computer system. The computer system provides the PMD system with computer-executable instructions and controls the various components of the PMD system.

In order to deposit fluid material and/or form microstructures on a substrate, it is useful for the PMD tool to move relative to the substrate. The relative motion of the PMD head and the substrate can be achieved by moving the substrate and/or the PMD head. This movement may be linear or rotational.

For linear motion, the PMD system may use a linear motor. In one embodiment, the PMD system includes a linear motor that is configured for a clean room environment, having air bearings so that linear motion of the PMD head does not create any particles from friction that can contaminate the clean room environment. The PMD system may also include hepa filters, special bearings, motors, and assemblies to meet the stringent clean room requirements. The mobility provided by the linear motor is also beneficial for enabling PMD processes to be performed on large substrates, such as on rolls of plastic that cannot be rotated by the stage.

In certain embodiments, the PMD system includes means for rotating the PMD head to accommodate large substrates and certain PMD process requirements. Means for rotating the PMD head may include, but are not limited to, air bearings and magnetic relays. Rotating the PMD head is particularly useful for providing a pitch or angle of the nozzles with respect to the direction in which the fluid material is deposited on the substrate when it is impractical to rotate the stage, thereby decreasing the space between the deposited fluid material and increasing the resultant resolution.

Resolution can also be improved when straight lines are deposited on the substrate by rotating the PMD system and/or substrate so that the substrate moves in the same direction as the line(s) to be deposited. In this manner, each droplet that is deposited on the substrate will land on the track or tail of the previous droplet, thereby minimizing the effects of any irregularly shaped droplets and improving the overall resolution of the sides of the line(s).

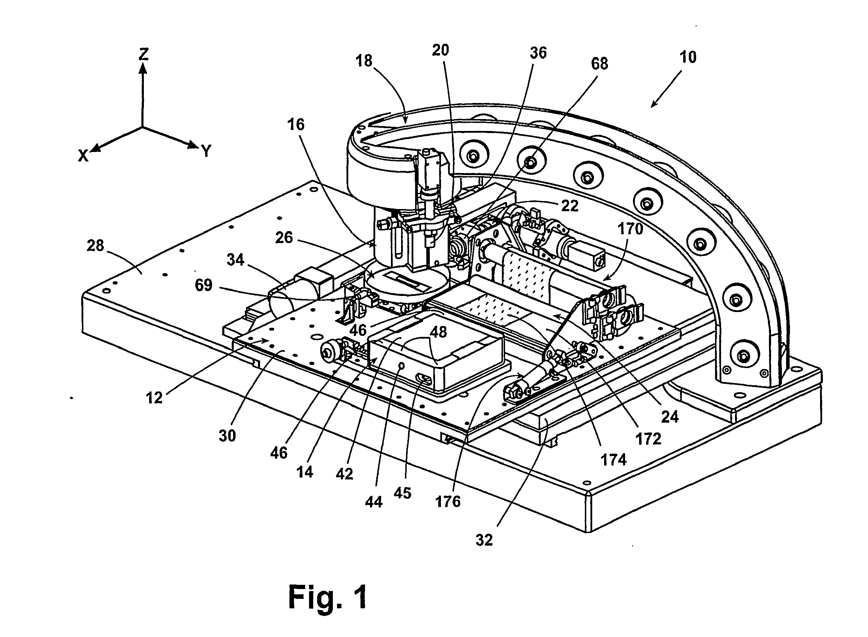

Figure 1 illustrates several components of the PMD system 10, including the stage 12, the vacuum chuck 14, the PMD head 16, the PMD head support 18, the alignment component 20, the drop diagnostics assembly 22, the maintenance station 24, and the capping station 26.

As shown, the stage 12 and the PMD head support 18 are mounted to a fixed surface 28. The fixed surface 28 may include any surface suitably configured to provide stability to the PMD system 10 and to minimize vibrations capable of compromising the precision of the PMD system 10 during use. According to one embodiment, the fixed surface 28 includes a granite block. However, it will be appreciated that the fixed surface 28 may also include other materials and structures.

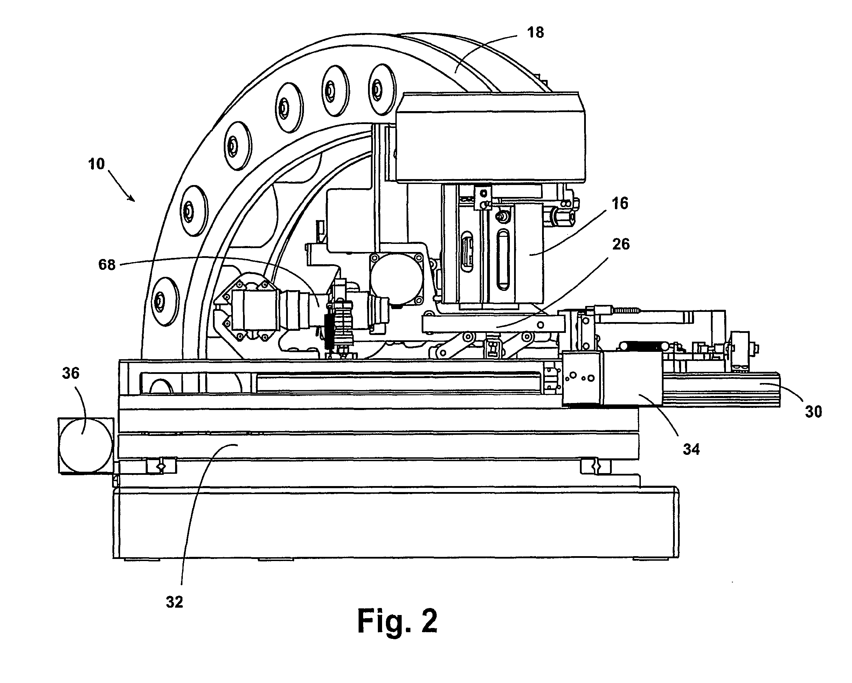

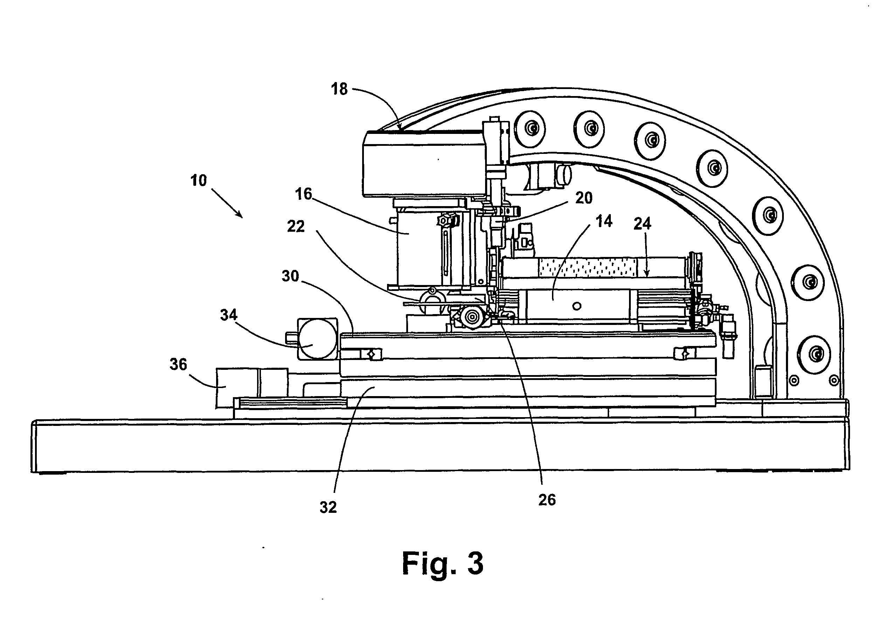

Figures 2 and 3 illustrate the respective side and front views of the PMD system 10 of Figure 1. As shown, the stage 12 comprises a top mounting plate 30 and an intermediate plate assembly 32, each of which is configured to move in one of two different directions. As shown in Figures 1-3, the vacuum chuck 14, the capping station 26, the maintenance station 24, and the drop diagnostics assembly 22 are mounted on the top mounting plate 30 of the stage 12, and will therefore move with the top mounting plate 30.

In particular, the top mounting plate 30 is connected to a first motor 34 configured to drive the top mounting plate 30 in a first direction, illustrated as the X axis in Figure 1, and the intermediate plate assembly 32 is connected to a second motor 36 configured to drive the intermediate plate assembly 32, as well as the top mounting plate 30, in a second direction, shown as the Y axis in Figure 1. The first and second motors 34 and 36 may be operated exclusively or simultaneously to provide any desired movement of the stage 30, relative to the PMD head 16, in the horizontal X-Y plane. Accordingly, it will be appreciated that the stage 12 is also capable of moving simultaneously in both the X and Y directions of the X-Y plane. The mobility of the stage 12 in the X-Y plane is useful for moving a substrate mounted on the stage 12 into alignment with the PMD head 16 and for moving the substrate during the PMD processes of the invention, as generally described below. It will be appreciated that the stage 12, as configured, is configured for clean room environments, where moving parts, particularly moving parts that have solid surfaces moving against each other, generally cannot be used if the parts are positioned above the substrate.

The vacuum chuck 14 provides one suitable means for securing a substrate in a fixed position on the stage 12 during the PMD processes of the invention. Other structures and methods for retaining the substrate, including a roll-to-roll assembly for flexible materials, are considered within the scope of the invention.

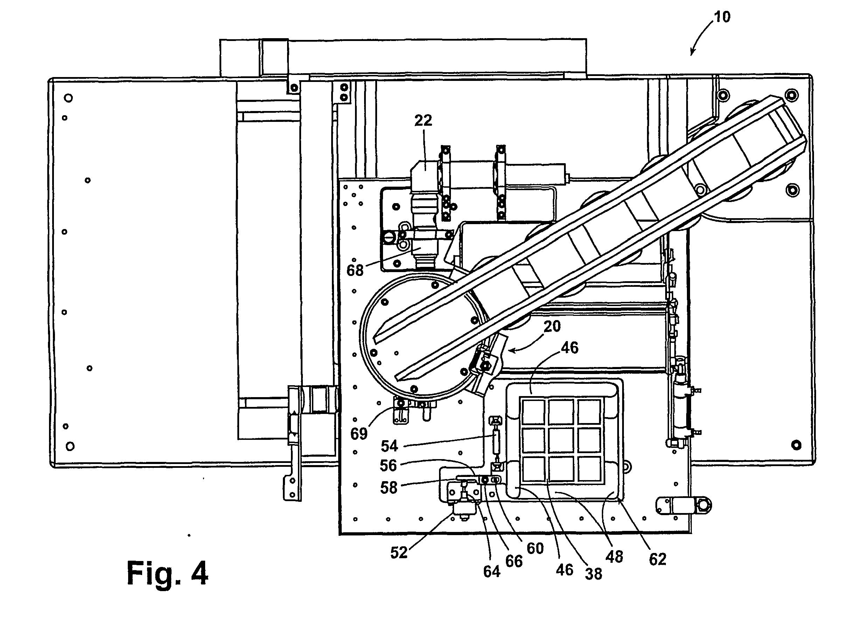

A substrate 38, shown in Figure 4, is securely held in place on the vacuum chuck 14 by negative air pressure created by the suctioning of air through the porous metal plate 42 of the vacuum chuck 14. The porous metal plate 42 can be seen in Figure 1. According to one embodiment, the porous metal plate 42 is a porous aluminum plate, such as Metaphor®, available from Portec Ltd., a subsidiary of M-Tec Holding Ltd. Winterthur. However, other types of porous plates manufactured from other materials can also be used. Air is suctioned through the porous metal plate 42 by any suitable means, such as a vacuum or a pump, which can be connected to a suction port 44 on the vacuum chuck 14.

The vacuum chuck 14 may also include a coupling 45, which can be configured to interconnect devices within the vacuum chuck 14 with control devices of the PMD system 10. The coupling 45 provides a serial port through a DB9 connector, for example, which couples devices within the vacuum chuck 14 with a control system. According to one embodiment, a heating source and temperature sensors are contained within the vacuum chuck 14 and are connected with a control system to enable an operator to control the temperature of the porous metal plate 42.

As shown in Figure 4, a substrate 38 can be mounted on the vacuum chuck 14 between ledge supports 46 that are configured to align the substrate 38 on the vacuum chuck 14. Alignment of the substrate 38 on the vacuum chuck 14 is useful to ensure fluid manufacturing material is deposited on the substrate 38 in the appropriate locations. It should be noted, however, that the act of mounting the substrate 38 on the vacuum chuck 14 does not ensure that the substrate 38 is aligned with the PMD head 16 to the precise tolerances that are required to perform the PMD processes of the invention. Thus, the substrate 38 should be precisely aligned with the PMD head 16 according to the methods of the invention.

Initial alignment between the substrate 38 and the PMD head 16 is provided when the substrate 38 is mounted on the vacuum chuck 14 against the ledge supports 46 because the vacuum chuck 14 is already aligned with the PMD head 16. In order to ensure the vacuum chuck 14 is precisely aligned with the PMD head 16, two reference points 48 are provided on the vacuum chuck 16. The reference points 48 are optically detected by an alignment component 20, discussed in more detail below, which generally determines whether the vacuum chuck 14 is in proper alignment with the PMD head 16. If the vacuum chuck 14 is not in proper alignment then the vacuum chuck 14 is moved until the desired alignment is obtained.

To provide proper alignment of the vacuum chuck 14 and the substrate 38, the vacuum chuck 14 includes a stepper motor 52, a spring 54, and a pivot arm 56. The pivot arm 56 is connected with the stepper motor 52 at a first end 58 and is connected with the vacuum chuck 14 and a spring from a second end 60. The vacuum chuck 14 is also pivotally connected with the stage 12 at a pivot corner 62. This generally enables the vacuum chuck 14 to pivot about the pivot corner 62 when the stepper motor is operated.

According to one embodiment, the stepper motor includes an extension arm 64 that can be controllably extended to apply a force to the first end 58 of the pivot arm 56, thereby causing the pivot arm 56 to pivot in a clockwise rotation (from the top view of Figure 4) about a pivot point 66. Because the second end 60 of the pivot arm 56 is connected with the vacuum chuck 14, this causes the vacuum chuck 14 to pivot about the pivot corner 62 in a counterclockwise rotation. The vacuum chuck 14 can also be pivoted in the opposite direction. For instance, when the arm 64 of the stepper motor 52 is retracted, the spring 54 contracts and forces the second end 60 of the pivot arm 56 to move towards the spring 54, thereby causing the vacuum chuck 14 to pivot about the pivot corner 62 in a clockwise rotation.

Pivoting of the vacuum chuck 14 may be performed by the PMD system 10 at any time to obtain a desired alignment of the vacuum chuck 14 or the substrate 38 with the PMD head 16. Pivoting the vacuum chuck 14 can also be performed to create a desired misalignment of the substrate 38 with the PMD head, which may be desired when forming certain microstructures on the substrate 38. According to one embodiment, desired alignment between the substrate 38 and the PMD head 16 can also be obtained by rotating the PMD head 16 with respect to the substrate 38 at the PMD head support 18, such as for example, with a turret, as described below.

Specific reference is now directed to the alignment component 20. As shown in Figures 1 and 3, the alignment component 20 is fixedly attached to the PMD head support 18. According to one embodiment, the alignment component 20 comprises a camera. The camera may have any combination of digital and optical capabilities and is preferably linked to optical/digital recognition modules that are configured to identify the reference points 48 on the vacuum chuck 14, as well as precise alignment marks etched on the substrate 38. These alignment marks, which are referred to herein as fiducial marks, are typically preformed on the substrate 38 and are generally too small to be seen by the naked eye. In one embodiment, the fiducial marks include perpendicular cross-hairs etched on the substrate 38.

Fiducial marks are used, according to one embodiment, as a basis for aligning the substrate 38 with the PMD head 16 because alignment to the edge of the substrate 38 alone is typically not accurate enough to form microstructures on the substrate 38 with the precision that is required for manufacturing certain products. For example, in one embodiment, the PMD system 10 deposits polymer droplets onto pixels of a PLED display within plus or minus about ten microns, which is roughly one-tenth the diameter of the human hair. It will be appreciated that the ability of the PMD systems of the invention to precisely deposit fluid manufacturing material with such accuracy is an improvement over the prior art.

When the substrate 38 is mounted on the vacuum chuck 14, the PMD system 10 automatically uses the camera and optical recognition modules associated with the alignment component 20 to identify the fiducial marks or other reference markings on the substrate 38. The vacuum chuck 14 or PMD head 16 is then automatically pivoted or rotated, as required, to correct any misalignment between the PMD head 16 and the substrate 38. In this manner, alignment existing between the PMD head 16 and the substrate 38 is obtained, in a matter of seconds, to tolerances within about 3 microns. Finally, once the desired alignment is obtained, the PMD system 10 is capable of precisely depositing droplets of the fluid material onto predetermined locations of the substrate 38 according to the processes of the invention.

According to one embodiment, microstructures are formed on the substrate 38 as droplets are deposited from the PMD head 16 while the substrate 38 is moved beneath the PMD head 16 on the stage 12. For instance, rows of droplets can be formed on the substrate 38 when the stage 12 moves the substrate 38 below the PMD head along the X axis. The stage 12 can also be moved along the Y axis between the deposition of rows, thereby enabling a plurality of rows to be formed. The stage can also be moved in any combination of directions along X and Y axis to enable a variety of structures to be precisely formed over any portion of the substrate.

Although alignment of the substrate 38 with the PMD head 16 can be adjusted, as described above, it can be thwarted when the nozzles of the PMD head 16 do not fire properly. The PMD head 16 may include, for example, any number of nozzles. According to one embodiment, the PMD head 16 includes a nozzle assembly (not shown) having between about one and about 256 nozzles. If even a single nozzle is misfiring then the alignment of the substrate 38 with the PMD head 16 can be defeated. Accordingly, it is important to identify the firing characteristics of each nozzle and to correct any firing irregularities that may exist. Once the firing characteristics of the individual nozzles are known, it is possible to individually control the nozzles with the computer modules of the invention to achieve the desired discharge of the fluid material from the nozzles.

The drop diagnostics assembly 22, shown in Figures 1-4, is provided to measure and identify the firing characteristics of the individual nozzles of the PMD head 16. The drop diagnostics assembly generally includes a camera 68, which may have any combination of digital and optical capabilities, and is preferably linked to optical/digital recognition computer modules that are configured to identify the different firing characteristics of the individual nozzles.

According to one embodiment, the drop diagnostics assembly 22 identifies the firing characteristics of the individual nozzles by capturing various images of the droplets as they are discharged out of the nozzles and by analyzing the drop characteristics of the droplets. If a single nozzle of the PMD head is not firing properly, the drop diagnostics assembly and corresponding modules detect the error. The PMD system 10 then tries to automatically repair the nozzle with maintenance procedures, which are described below. If the error cannot be automatically corrected, the PMD system 10 warns the operator and manufacturing is paused, thereby preventing costly losses in device yields. The PMD head 16 can then be repaired or replaced by the operator, if required.

According to one embodiment, the camera 68 of the drop diagnostics assembly 20 is a right-angle camera 68 configured to fit on the stage 12. A backlight, such as strobe light 69, is also provided to enhance the quality of the images captured by the camera 68 and for capturing an image of the droplet in flight, as is well known in the art of photography. To perform drop diagnostics, the PMD head 16 is moved between the camera 68 and the strobe light 69, above the capping station 26. Droplets are then discharged from the nozzles of the PMD head 16 into the capping station 26. The characteristics of the droplets and the firing characteristics of the nozzles are then determined, as described below, upon capturing two orthogonal images of the droplets discharged from the nozzles. It is preferred that the nozzles being tested are centered in the camera's field of view for maximum accuracy and that they are tested individually.

According to one embodiment, a first image is taken of a first droplet when the PMD head is in a first position and the second image is taken of a second droplet fired from the same nozzle after the PMD head 16 has been rotated by 90 degrees. According to another embodiment, the two images are taken simultaneously of a single droplet using two orthogonally mounted cameras. Upon capturing the images of the droplets, the optical recognition modules of the PMD system 10 use the images and firing information to calculate the drop volume, drop velocity, drop nozzle placement, drop angle of deviation, and drop formation, thereby enabling the PMD system 10 to compensate for any deficiencies or variation between the nozzles of the PMD head 16.

Drop volume may be calculated by using the height and/or width of the droplet, or imaging the area by one or more cameras to calculate the volume. In both variations, the images captured by the camera 68 are used to calculate or estimate the three-dimensional shape of the droplet, depending on the required accuracy and precision for a particular application. If the droplet volume is too large or too small, the PMD system 10 automatically compensates by adjusting the frequency at which the nozzle discharges the droplets. For instance, the amount of voltage or the wavelength sent to the PMD head 16 can be varied to compensate for the flawed drop volume. With less power, a smaller droplet will be ejected; with more power, a larger droplet will be ejected. Once a correction is made, it may be necessary to reanalyze the nozzle and corresponding droplets in an iterative process to refine the adjustments.

A second way to correct problems associated with drop volume is to change the number and frequency of the droplets that are deposited during the PMD process. Although the drop volume of individual droplets will remain the same according to this method, the quantity of fluid material deposited on the substrate can be controlled by increasing or decreasing the frequency at which the droplets are deposited. This method of compensating for problems with drop volume is particularly useful when depositing droplets in rows or when multiple drops are needed to achieve the desired drop volume. This method of altering the frequency at which the droplets are deposited is referred to herein as microclocking.

Microclocking is one means provided by the invention for overcoming deposition speed performance limitations such as starvation, which refers to the condition in which fluid material is not replenished into the fluid chamber quickly enough to be jetted out of the nozzle. Existing print head technologies typically limit the clock frequency of the print head to the maximum frequency at which printing can be accomplished before starvation occurs. It should be appreciated by one skilled in the art that this also places practical limits on the resolution of the PMD head, particularly when considering that multiple nozzle heads typically work off of a single clock.

To overcome the limitations of the prior art and to obtain individual control over the nozzles of the PMD tool, the present invention utilizes a method of microclocking to artificially increase the frequency of clock cycles or signals sent to the PMD tool far beyond the intended deposition speed. The PMD system is able to use the additional clock cycles to control the resolution and the quantity of fluid material deposited during the PMD process. In one embodiment, the PMD system increases the frequency of clock cycles by a ratio of 10 to 1 over the intended deposition speed, thereby providing the PMD system with the ability to control the dot placement within one tenth of the deposition frequency.

Even though the deposition frequency cannot exceed the limitations of starvation, it is still possible to send clock cycles and data to the PMD tool at the microclock rate because the computer-executable instructions of the PMD system will not permit the actual deposition data to exceed the starvation rate. This is accomplished in the present embodiment, by sending "filler data," or blank data to each nozzle approximately 9 out of every 10 clock cycles. The PMD tool therefore receives multiple times more data than it can use to deposit proportional to the microclock divided by the actual deposition clock speed. In this manner, it is possible to increase the resolution of existing print head technology by 10 times or more without impacting the maximum deposition speed.

Microclocking is particularly beneficial for improving resolution of the deposited fluid material on a substrate. In particular, the beginning and ending of a line or shape can be more precisely controlled. In the current embodiment, in which the frequency of clock cycles is set at a ratio of 10 to 1 over the intended deposition speed, the fluid material can be deposited by the PMD tool ten times more precisely than previously allowed, to within one-tenth of the previous width of allowed resolution at the same deposition speed.

Microclocking is also useful for controlling the volume of the fluid material that is deposited on the substrate. For example, if it is desirable to have more fluid deposited to either compensate for a weak nozzle or to just add to the material thickness, the appropriate nozzle is set to jet a droplet of the fluid material at a higher frequency than the other nozzles. For example, the designated nozzle may be set to jet 1 out of every 9 clocks where the other nozzles are jetting 1 out of every 10 clocks. This technique deposits approximately 11 % more fluid material by the designated nozzle than from the other nozzles. Similarly, nozzles that otherwise deposit too much fluid can be caused to deposit less frequently.

Microclocking is also particularly useful when the PMD tool is rotated and the nozzles are not vertically aligned, when trying to accommodate for differences in drop velocity or angle of deviation, when higher resolution is desired for placing individual dots, and when there is a desire to carefully control fluid quantities that are deposited on the substrate.

Microclocking, as it has been described, generally requires the frequency of clock cycles sent to the PMD tool to be multiple times higher than the intended deposition frequency. The ratio of the microclocking frequency to the deposition frequency controls the potential increase in resolution. The computer-executable instructions that produce the dot patterns for jetting the fluid material must recognize the potential increase in resolution and inject "filler data" of zeros to be sent to the PMD tool for the wait cycles. The number of wait cycles to each deposition cycle equals the ratio of the microclocking frequency to the deposition frequency.

Microclocking is also useful for compensating for "pitch," which is the rotation of the PMD tool relative to the motion of the substrate during the PMD process. Pitching the PMD tool results in a resolution that is accurate to within a fraction of a dot, based on the ratio of the microclocking frequency to the actual deposition frequency. Microclocking compensates for pitch by injecting "filler data" which equals the space created by the offset of the angled nozzles relative to the vertical motion of the substrate.

Drop velocity is calculated by taking the time delay from the nozzle fire time (Tf) and the camera strobe fire time (Ts) to obtain the travel time Tf - Ts = Tt. The optical recognition module is then used to find the distance traveled (Dt), which is the distance between the center of the droplet and the nozzle. The drop velocity is finally calculated by dividing the distance traveled by the travel time (Dt/Tt).

Drop velocity determines when the drops of fluid material hit the substrate, which is particularly significant when the substrate is moving. Problems with drop velocity are corrected by offsetting the firing time of the droplets to compensate for drop velocities that are too high or too low. Calculating an adjustment for the firing time can be determined, according to the invention, because the drop velocity and the distance to the substrate are known. For drop velocities that are too high, the firing time is delayed; for drop velocities that are too low, the firing time is accelerated.

Drop nozzle placement is determined by adjusting the illumination cycle of the strobe light 69 until the droplet is photographed leaving the nozzle. Then the exact location or placement of the nozzle can be identified. Correction for an irregular drop nozzle placement is made in conjunction with correction for drop angle of deviation, as discussed next.

Drop angle of deviation is determined by jetting a drop of the fluid material out of the nozzle a predetermined distance (which can be done because of the known drop velocity) and then identifying the center of the drop at that distance. Next, the center of the droplet and the drop nozzle location are used to calculate the angle of deviation. According to one embodiment, this is done in both the X and Y directions of a horizontal X-Y plane to get the true three-dimensional drop angle of deviation.

Drop angle of deviation and irregular drop nozzle placement are corrected by taking the nozzle placement and the angle of deviation and calculating where the droplet will fall compared to where it is expected to fall. Next, the firing time is accelerated or delayed to compensate for any discrepancies between the expected and actual trajectory of the droplet.

Drop formation is determined by analyzing the images captured by the camera 68 with the optical recognition modules to see if there are any anomalous shapes outside of the main droplet. Primarily, this is done to check whether the droplet has significant tails or corresponding satellites. The term "satellites" generally refers herein to fluid material discharged contemporaneously with the droplet, but which has become detached from the droplet.

Drop formation analysis is a pass/fail test. If the droplet does have an anomalous shape or corresponding satellites, the PMD system automatically corrects the problem in one of two general ways. The first option is to change the voltage and pulse width settings of the nozzle discharging the droplet with computer-executable instructions from the PMD system 10. This type of correction is typically performed when a new fluid material or PMD head 16 is being used and flaws are widespread across the entire nozzle assembly of the PMD head 16. When the PMD head 16 and fluid material are not new, however, it is likely that the nozzles of the PMD head are clogged or in need of repair. Accordingly, the second option for correcting undesired drop formation is to perform maintenance on the PMD system 10 to unclog or repair the nozzles of the PMD head 16. If automatic maintenance cannot repair the nozzles, the machine warns the user before proceeding, thereby avoiding unnecessary waste to materials and products. This is critical for high yield and costly manufacturing processes.

The drop diagnostics assembly 22 and alignment component 20 of the PMD system 10 represent an innovation over existing printing technologies because of the accuracy enabled by the drop diagnostics assembly 22 and alignment component 20. Moreover, existing printing and patterning systems do not have the ability to measure or precisely align the position, angles, and operation of the nozzles with a substrate 38, nor has there been any motivation in such systems to provide the precise alignment necessary for high yield and costly manufacturing processes. The development of these systems for aligning the PMD head 16 and corresponding nozzles with the substrate 38 enables the PMD processes of the invention to create microstructures that require a high degree of precision.

The infinite variable positioning provided by the PMD system 10 according to the invention provides uniformity over a large area. Further, the PMD system 10 according to the invention controls pitch in addition to movement in the *x* and *y* axes. More specifically, rotation of the PMD head 16 is useful for changing the pitch of a nozzle assembly with respect to the substrate in order to control the precision of the PMD processes. Further, the optical recognition and correction provided by the PMD system 10 further allows drop size control. Moreover, the PMD system 10 according to the invention provides such uniformity, variability and control in a clean application because the PMD head 16 does not come in contact with the substrate, only the material deposited by the PMD head.

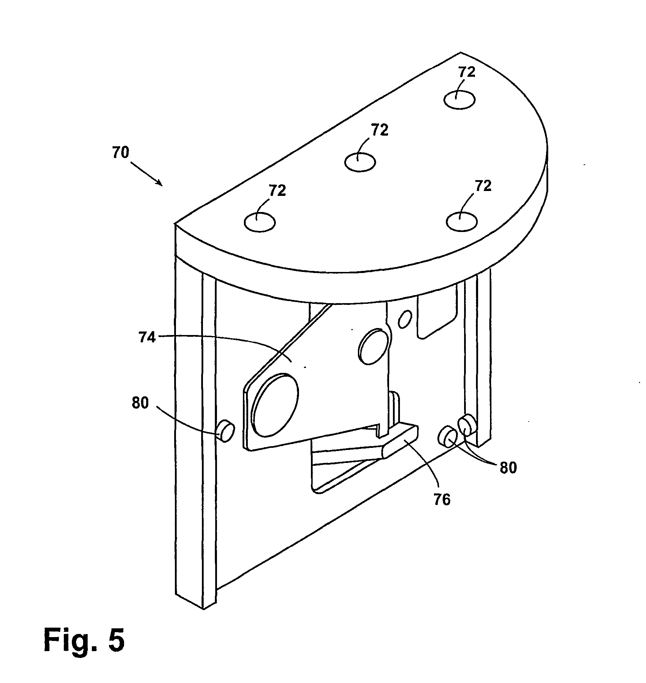

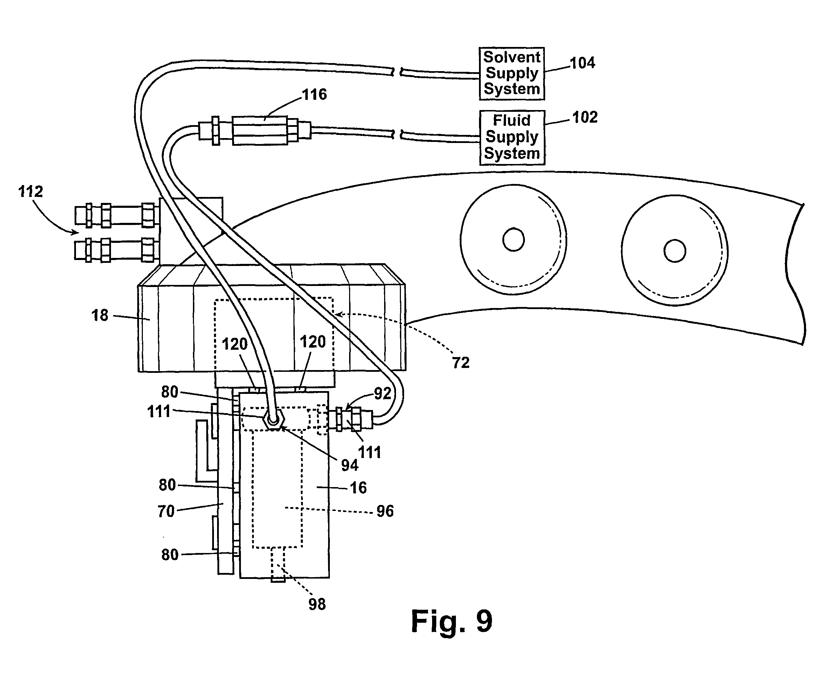

Although alignment of the PMD head 16 with the substrate 38 has thus far been described as a step to be performed after mounting the substrate on the PMD system, it will be appreciated that alignment can also be performed whenever the PMD head 16 is replaced or otherwise mounted on the PMD head support 18. Figures 5-7 illustrate a mounting bracket 70 used according to the invention to couple the PMD head with the PMD head support 18. As shown, the mounting bracket 70 includes a plurality of holes 72 through which bolts can pass to secure the mounting bracket 70 to the PMD head support. Further, the mounting bracket 70 includes a latching mechanism 74 that is configured to securely hold the PMD head 16 in placement against the mounting bracket 70. The latching mechanism 74 generally includes latching arms 76 configured to clasp onto corresponding recesses formed in the PMD head 16. The latching arms 76 are operated by a lever 78, shown in Figure 9, that is located on the opposite side of the mounting bracket 70. The mounting bracket 70 also includes datum points 80 that are used to ensure the PMD head is properly aligned against the mounting bracket 70 when the latching arms 76 secure the PMD head against the mounting bracket 70.

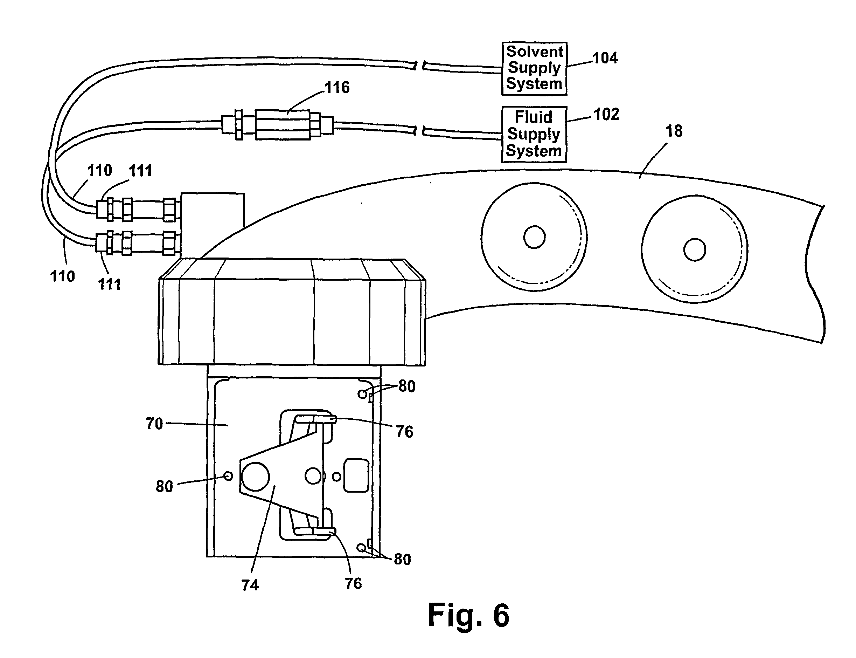

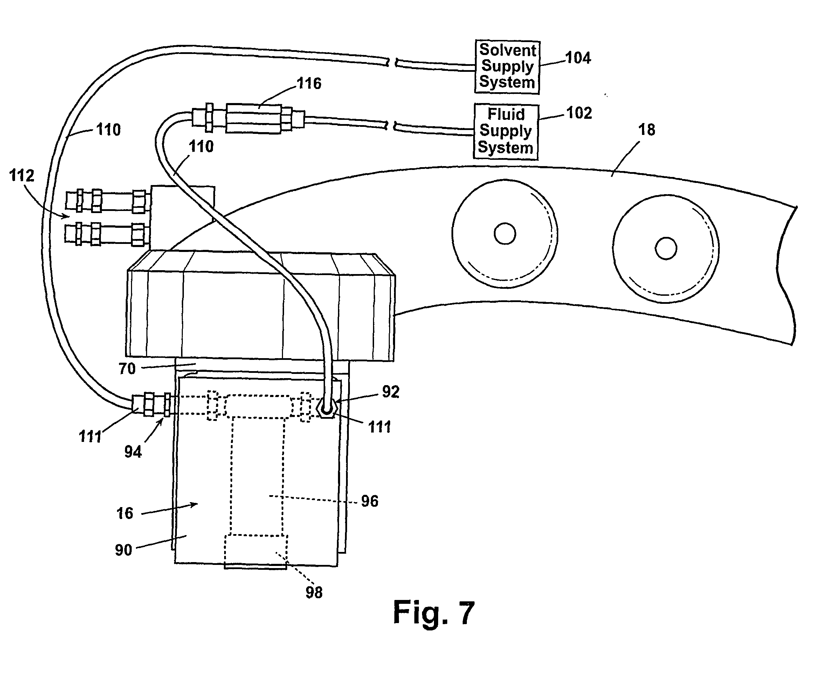

Figure 7 illustrates one embodiment of a PMD head 16 that is connected with the mounting bracket 70 of Figure 6. As shown, the PMD head 16 includes a housing 90, a fluid material inlet port 92, a solvent inlet port 94, internal PMD head components 96, and a nozzle assembly 98. During use, fluid material enters the PMD head 16 through the inlet port 92 and is channeled through the internal PMD head components 96 to the nozzle assembly 98 where it is finally discharged onto the substrate through the nozzles of the nozzle assembly 98.

According to one embodiment, the PMD head components 96 include a fluid material reservoir, a diaphragm, and a piezoelectric transducer, such as, for example a Lead Zirconate Titanate: Pb(Zr,Ti)O3, or "PZT" transducer which generates acoustic waves suitable for discharging the fluid material through the nozzles of the nozzle assembly 96. The diaphragm and piezoelectric transducer generates acoustic pulses when power is supplied to the piezoelectric transducer. Droplets of the fluid material are discharged from nozzles included in the nozzle assembly 98 when the force of the acoustic pulses is sufficient to overcome the surface tension of the fluid manufacturing material. The velocity and volume of the discharged droplets are controlled by altering the power supply to the piezoelectric transducer.

The PMD systems of the invention are capable of controlling the volume of the droplets that are discharged from the PMD head 16. According to one embodiment, the PMD head discharges fluid material droplets as small as approximately ten picoliters and at a frequency of up to thousands of droplets per second. Because the desired volume and frequency of the droplets may vary to accommodate different types of fluid manufacturing materials, substrates and microstructure formations, it will be appreciated that the invention is not limited to discharging droplets of fluid materials of any particular volume, frequency, or form.

Conventional ink jet heads ("jet heads") can be readily adapted for use with at least some fluid materials of the invention. Accordingly, the invention also extends to the use of existing jet heads or jet heads that will be created in the future, including those manufactured currently or in the future by third parties and those that have been or will be manufactured for the purpose of jetting ink in ink jet printing systems.

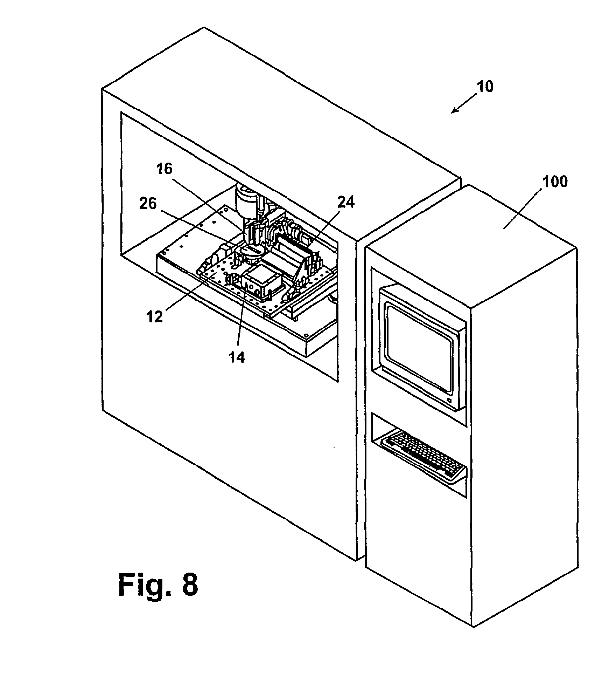

According to one embodiment, the PMD systems 10 of the invention include a computer control system configured to execute computer-executable instruction for generating various digital waveforms, current power supplies, and digital signals, as required by the various print head technologies. The computer system may be physically incorporated within the separate PMD system components, or alternatively, as shown in Figure 8, the computer system may be embodied as a stand-alone computer system 100 that is connected with each of the different PMD system components, thereby enabling an operator to control each of the PMD system components from the stand alone computer system. The computer system 100 may include the various control systems that are described herein.

One benefit of the computer system 100 is that it more easily enables various PMD heads 16 having different capabilities and functionality to be interchangeably used by the PMD systems 10 of the invention. For instance, according to one embodiment, the computer system 100 separates the electronics of existing print head technologies into two different sections, a master electronics section and a personality electronics section, which can be mounted within the individual PMD heads 16 or the standalone computer system 100.

The master electronics section contains the basic signals and information that are basic to all PMD heads 16; namely, the dot pattern to be deposited (deposition data), a two-dimensional waveform defined by slope, duration, and amplitude, the ground and max voltages used in the PMD head 16, and the clock speed at which the head device is designed for depositing drops of fluid material. The master electronics are typically stored on a computer programmable board that permits these definitions to be made and stored for each type of PMD head 16.

The personality electronics section contains firmware that is specific to certain head manufacturers and models, often requiring custom signals and connections. The personality electronics receives the customized waveforms and data from the master electronics during use. Typically the personality electronics are stored in a computer-readable medium, such as a customized personality card. In one embodiment, a custom personality card is developed for each type of PMD head 16 used by the PMD system 10.

By defining the electronics in this way, the PMD systems 10 of the invention are head independent, thereby allowing interoperability between various PMD heads 16, and thereby enabling the PMD system 10 to accommodate for the various existing and newly developing technologies. In other words, it is possible to replace the PMD heads 16 used by PMD system 10 without having to make any hardware modifications to the PMD system 10. Even piezoelectric heads of different sizes from different manufacturers can be used and incorporated within the PMD heads 16 of the invention, including heads from third parties and those that currently exist or that were originally made to deposit fluid materials other than the fluid materials of the invention. It should be appreciated that this is an advancement over the prior art in which existing piezoelectric heads are designed for a particular head technology and for a single type of piezoelectric head, which limits existing devices from being updated to accommodate new and developing piezoelectric head technologies. Another benefit of defining the electronics in this manner is that it enables the nozzles of the PMD head to be individually controlled to correct any irregularities that may exist.

Returning now to Figures 6 and 7, it is shown how tubing 110 is used to interconnect the PMD head 16 with a fluid material supply system 102 and a solvent supply system 104. As shown, the tubing 110 may include quick release fittings 111 that are configured for conveniently moving the tubing 100 from the PMD head 16 to a holding device 112 during periods of nonuse, such as, for example, when the PMD head 16 is being interchanged with another.

Figures 6 and 7 also illustrate how a filter 116 may be connected to the tubing 110 to ensure that the fluid material supplied to the PMD head 16 is clean. Although not shown, a filter may also be provided to ensure that the supply of solvent to the PMD head 16 is clean. According to the invention, and as described below in more detail, solvent is supplied to the PMD head 16 to purge the PMD head of a fluid material during purging procedures.

Turning now to Figure 9, it is shown how the mounting bracket 70 can be rotated with respect to the PMD head support 18. As shown, the mounting bracket 70 has been rotated ninety degrees from the position shown in Figures 6 and 7. Rotation of the mounting bracket 70 is enabled, according to the invention, by a turret 72 that is rotatably connected to the bottom of the PMD head support 18. Rotation of the PMD head 16 is useful for facilitating the capture of orthogonal images taken by the drop diagnostics assembly, as described above. Rotation of the PMD head 16 can also be useful for changing the pitch of the nozzle assembly 98 with respect to the substrate in order to precisely control the distance between rows of droplets on a substrate.

Figure 9 also shows how, according to one embodiment, the datum points 80 bias against the PMD head 16 to ensure alignment of the PMD head 16. The datum points 80 preferably comprise hardened steel capable of providing exact alignment of the PMD head 16 with the mounting bracket 70. Additional datum points 120 may also be provided between the top surface of the PMD head 16 and the mounting bracket 70 to further facilitating alignment of the PMD head 16 with the mounting bracket 70. When the PMD head 16 is not properly aligned in the mounting bracket 70, the drop angle of the droplets fired out of the nozzles may be offset, in which case the drop diagnostics assembly detects and compensates for any misalignment, as generally described above. However, if misalignment is significant, it may be necessary to remount the PMD head 16 on the mounting bracket 70.

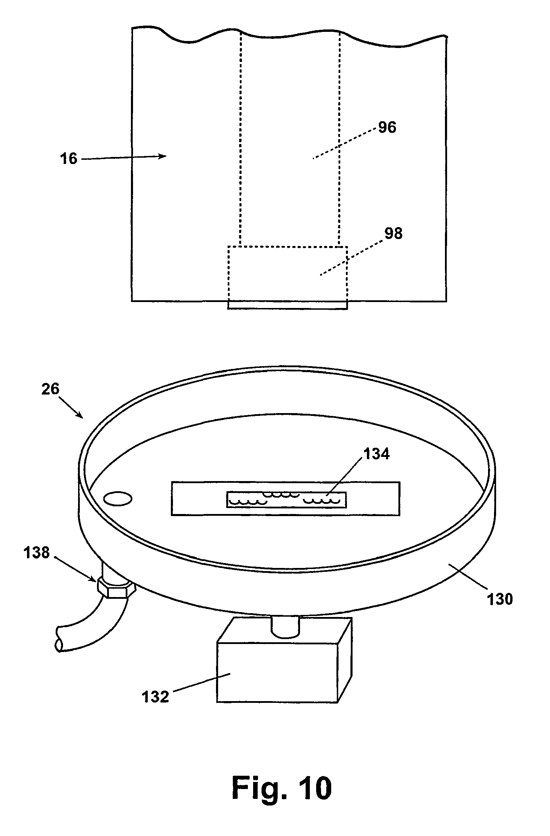

Attention will now be turned to Figure 10 for providing a detailed description of the capping station 26. As shown, the capping station 26 generally includes a tray 130 mounted on an extendable support 132, and a soaking reservoir 134. One purpose of the capping station is to receive and bathe the nozzles of the PMD head 16 during periods of nonuse to keep the nozzles from drying out and from becoming clogged. For instance, when the PMD head 16 is inactive for a period of time, the capping station 26 is moved directly beneath the PMD head 16 and the tray 130 is elevated by the extendable support 132 until the soaking reservoir 134 engages the nozzle assembly 98 of the PMD head 16. The soaking reservoir 134 is filled with a solvent that is compatible with the fluid material and keeps the nozzle assembly 98 from drying out. The soaking reservoir 134 can be supplied with the solvent by the PMD head 16 or by another supply means, such as, for example, with tubing connected directly to a solvent supply system (not shown).

Another purpose of the capping station 26 is to catch any fluid material deposited from the PMD head 16 during drop diagnostics. For example, during drop diagnostics the fluid material can be dropped onto any portion of the tray 130. Excessive fluid material and solvent falling onto the tray 130 is disposed of through a drain 138 that is connected to the tray 130.

According to one preferred embodiment, the PMD head is interchangeable and can be switched either manually or automatically. In one embodiment, the PMD head includes quick connect fittings and the PMD system includes means for automatically switching the PMD tools. As a matter of example, and not limitation, an interface on a gantry and the corresponding interface on the PMD head represent one suitable means for automatically switching the PMD head. The gantry is an arm to which the PMD head is removably attached. When the PMD head is to be switched with another PMD head, the PMD head is removed from the interface of the gantry, either manually or automatically, and is then placed in a tool holder. The replacement PMD head is then positioned on the interface of the gantry, either manually or automatically. After the new PMD head is attached, the gantry is positioned to a desired location for aligning, testing, and calibrating the PMD head.

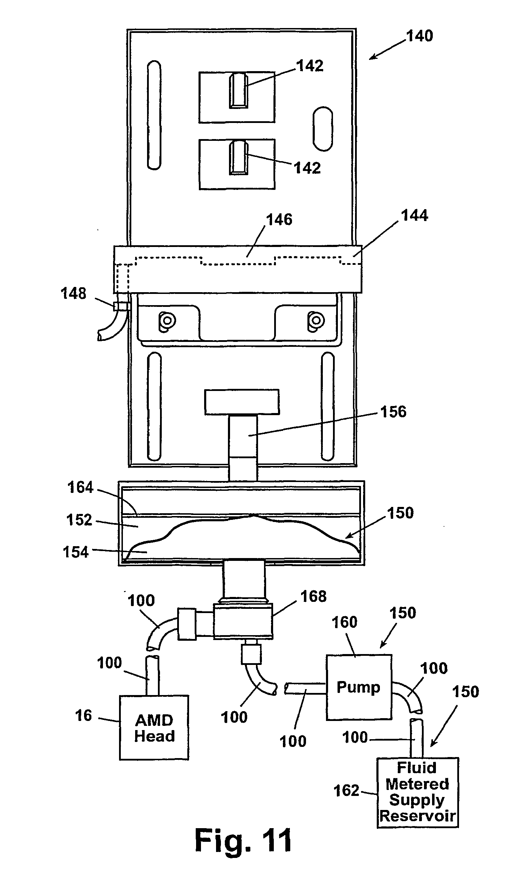

As shown in Figures 11-13, a docking station 140 can also be configured for bathing the nozzles of a PMD head 16 during periods of nonuse. The docking station 140 is particularly useful when the PMD head 16 is not going to be used for extended periods of time, or the PMD head 16 is only one of several PMD heads being used with the PMD system. In such circumstances, unused PMD heads are stored on an individual docking stations 140 to prevent the nozzles of the PMD heads from drying out.

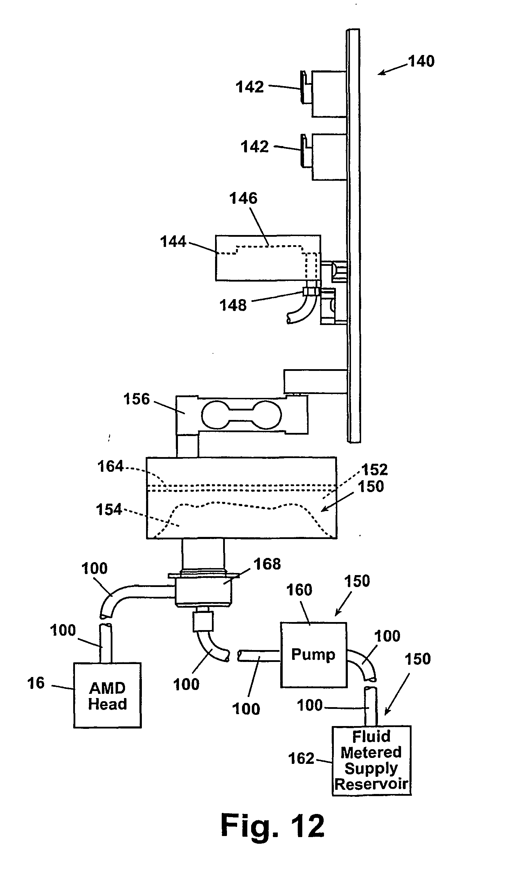

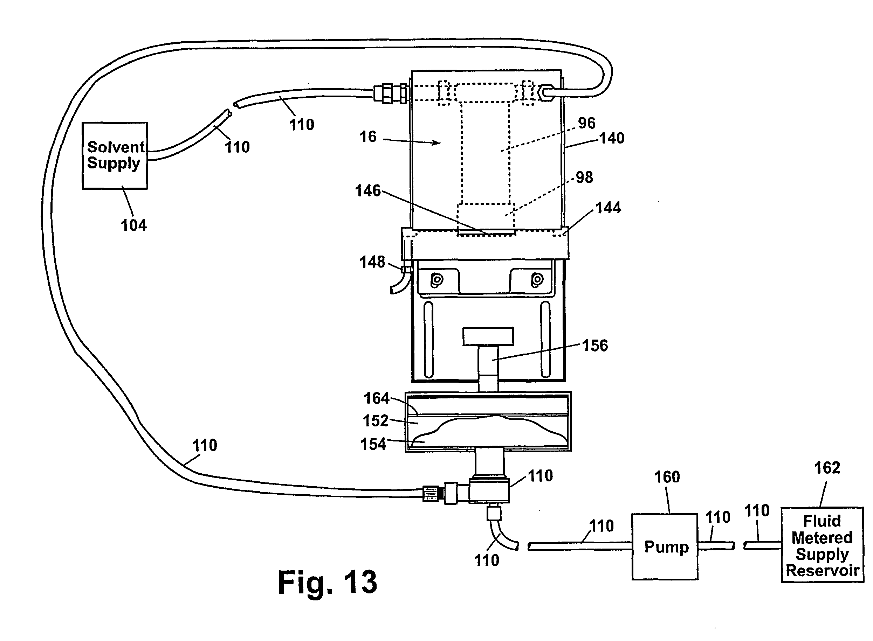

As shown in Figures 11 and 12, the docking station 140 includes mounting brackets 142 for receivably mounting the PMD head, a reservoir tray 144, and a soaking reservoir 146. The mounting brackets 142 are configured to securely hold the PMD head 16 in a position that places the nozzle assembly 98 of the PMD head 16 within the soaking reservoir 146, as shown in Figure 13. The reservoir tray 144 is configured to capture any excessive solvent that spills out of the soaking reservoir during the soaking of the nozzles. The reservoir tray 144 is also configured to capture any fluid material purged from the PMD head during a purging process, as described below. Accordingly, the reservoir tray 144 may also include a drain 148 for draining away any solvent and fluid material captured by the reservoir tray 144 during a purging process. The purged fluid material and solvent can be drained into a storage container (not shown) for easy disposal.

Figures 11 and 12 also illustrate how the docking station 140 can be configured to hold a portion of the fluid material supply system 150. In particular, the docking station 140 includes a storage chamber 152 that is configured to hold a working bag 154. During use, the fluid material is initially pumped into the working bag 154, where it is held until it is finally supplied to the PMD head. According to one embodiment, the storage chamber 152 is mounted on a weight gauge 156, which is configured to regulate the amount of fluid material contained within the working bag 154 at any given time. The weight gauge 156 is linked to computer modules and to a pump 160 configured to pump fluid material into the working bag 154 from a fluid material supply reservoir 162. According to one preferred embodiment, a two-way valve 168 controls the flow of the fluid material into and out of the working bag 154.

As shown in Figures 11-13, the storage chamber 152 is configured with a pressure control plate 164 configured to apply a predetermined pressure to the working bag 154 so as to ensure the supply of fluid material sent to the PMD head 16 from the working bag 154 is constant. This is important, according to one embodiment, for preventing any meniscus from forming in the fluid material at the nozzles of the PMD head that could potentially cause irregularities in the firing characteristics of the nozzles. According to another embodiment, the pump 160 directly supplies fluid material to the PMD head 16 and regulates the pressure of the fluid material.

According to one embodiment, the fluid material supply system 150, which generally includes the tubing 100, the working bag 154, the pump 160, and the fluid material supply reservoir 162, can be used under various pressures, based on the requirements of the various fluid materials and print head technologies. The materials of the fluid material supply system 150 are preferably configured to be durable and nonreactive with the solvents that are used by the PMD system. For example, according to one embodiment, the fluid material supply system includes an inert lining of polytetrafluoroethylene (such as Teflon®, available from DuPont E. I. DeNemours & Co.), although other materials can also be used.

As mentioned above, one function of the docking station 140 is to hold the PMD head 16 while the fluid material is purged out of the PMD head 16. Purging is sometimes required, for instance, when a single PMD head is used to deposit a variety of different fluid materials during a single PMD process, in which case the PMD head is purged between applications to prevent the different fluid materials from mixing.

To perform a purging procedure, the PMD head 16 is first mounted on the docking station 140, as shown in Figure 13. Next, solvent is pumped into the PMD head 16 from a supply of solvent 104. The solvent forces the fluid material through the PMD head until the PMD head is completely purged. The fluid material and any solvent purged from the PMD head 16 during this procedure are discharged into the reservoir tray 144 and drained away through the drain 148. Once purged, the PMD head 16 can be connected with a new supply of a fluid material. It will be appreciated that although the purging process has generally been described as occurring at the docking station 140, purging can also occur at the capping station in the substantially same manner.

Returning now to Figure 1, attention is directed to the maintenance station 24, which includes a roller assembly 170, a cushioned surface 172, and a blotting cloth 174. During use, the blotting cloth 174 is fed through the roller assembly 170 and over the top of the cushioned surface 172. When the PMD head 16 requires servicing, such as when the nozzles become clogged or when fluid material accumulates on the nozzle assembly, the maintenance station 24 is moved below the PMD head 16 so that the cushioned surface 172 is positioned directly beneath the nozzle assembly 98 of the PMD head 16. The cushioned surface 172 is then raised by a lifting mechanism, such as, for example, with the hydraulic lever assembly 176, until the blotting cloth 174 comes in contact with the nozzle assembly 98. This may be sufficient to blot away any fluid material buildup on the nozzle assembly 98. However, sometimes scrubbing is required.

To perform a scrubbing procedure on the nozzle assembly 98, the nozzle assembly 98 is held against the blotting cloth 174 while the blotting cloth 174 is fed through the roller assembly 170. This generally causes the blotting cloth 174 to frictionally engage the nozzle assembly 98, thereby cleaning the nozzles from any undesired buildup. According to one embodiment, the blotting cloth 174 comprises a nonabrasive material suitable for cleaning the nozzles without causing undue damage or wear to the nozzles. To further minimize any potential for damage to the nozzles, the cushioned surface 172 is configured to absorb any impact that could possibly occur between the PMD head 16 and the maintenance station 24.

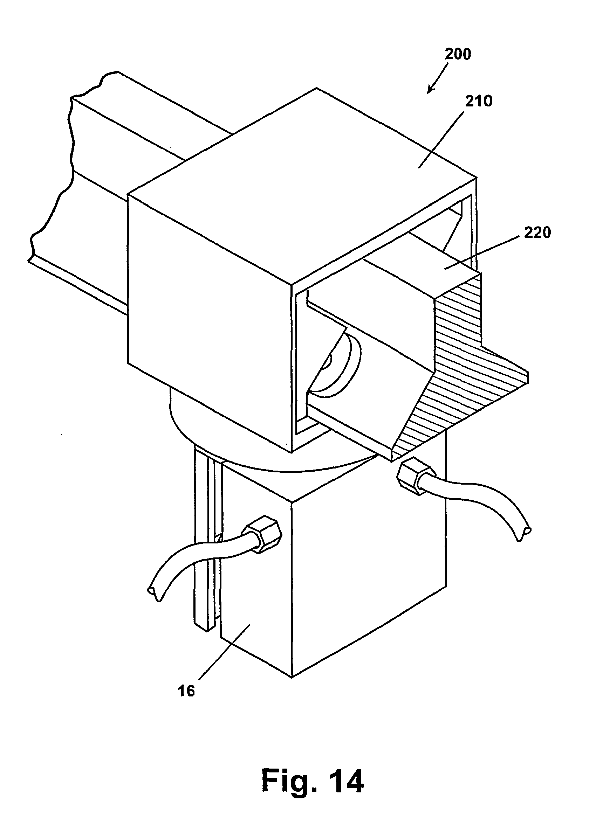

Attention is now directed to Figure 14 to illustrate one alternative embodiment of the invention. As shown, the PMD head support 200 may include a linear air bearing assembly 210 slidably mounted on a beam 220. The linear air bearing assembly 210 generally includes a linear motor with air bearings. Linear motors, which are well known in the art, utilize magnetic coils and slugs to eliminate friction between moving parts.

The use of the linear bearing assembly 210 is beneficial for enabling PMD processes to be performed in a clean room environment while providing the mobility required for performing PMD processes of the invention on large substrates. In particular, the mobility provided by the linear bearing assembly 210 generally eliminates the need for the stage 12 to completely move each of the PMD components beneath the PMD head 16. Instead, the linear bearing assembly 210 can be used to move the PMD head 16 above the PMD components. The linear bearing assembly 210 can also move the PMD head 16 during deposition of the fluid material on the substrate 38. However, in order to prevent surging of certain fluid materials within the PMD head 16, it is desirable not to move the PMD head 16 while fluid material is being discharged from the PMD head 16. Surging is caused when the fluid material is sloshed around inside of the PMD head, creating irregular pressures that can effect how droplets are formed and expelled from the nozzles.

The PMD systems of the invention have thus far been described as being capable of utilizing only a single PMD head at any given time. It will be appreciated, however, that the PMD systems of the invention can also be configured to simultaneously interoperate with multiple PMD heads. For example, the PMD systems of the invention may be configured with multiple PMD head supports, each including a separate PMD head.

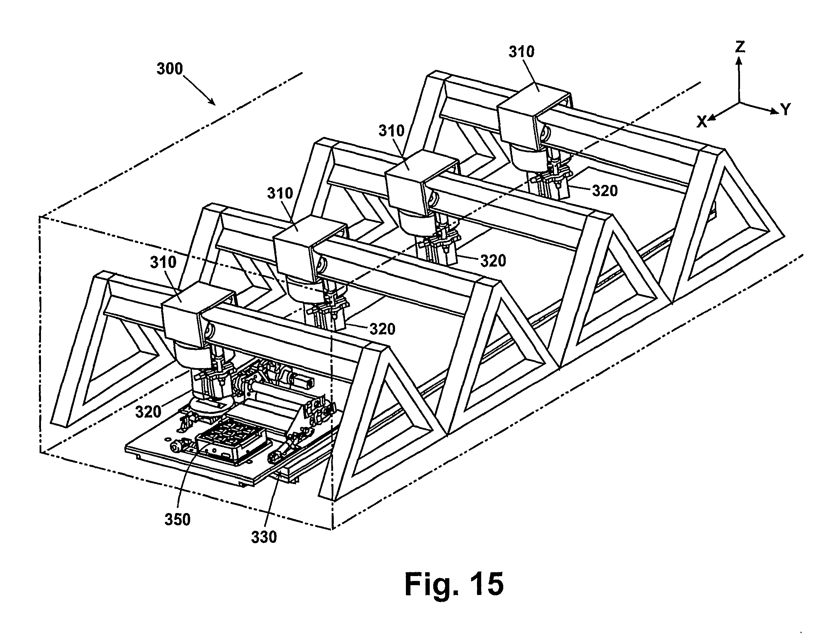

Figure 15 illustrates such an embodiment, in which a PMD system 300 is configured with multiple PMD head supports 310 and corresponding PMD heads 320 placed adjacently on a single manufacturing line. As shown, the PMD heads 320 are positioned above a stage 330 that is configured to move beneath each of the PMD heads 320 in the X direction of an X-Y plane. Each of the PMD head supports 310 is also configured to move the PMD head in the Y direction of the X-Y plane.

According to this embodiment, each PMD head 320 is configured to deposit a different fluid material from different fluid material supply systems (not shown). This embodiment can be particularly useful when depositing a variety of different colored polymers on a single substrate 350, such as when forming PLED displays. For example, according to one embodiment, a first PMD head can be equipped to deposit a base coat, a second PMD head can be equipped to deposit a red colored polymer, a third PMD head can be equipped to deposit a green colored polymer, and a fourth PMD head can be equipped to deposit a blue colored polymer. According to this embodiment, the substrate 350 is moved on the stage 330 sequentially beneath the different PMD heads 320, such that the base coat is first deposited on the substrate 350, then the red colored polymer is deposited on the substrate 350, then the green colored polymer is deposited on the substrate 350, then the blue colored polymer is deposited on the substrate 350.

It will be appreciated that this embodiment is useful for eliminating the need to flush or purge the PMD heads 320 between applications of the different fluid materials, which can take time. Purging the PMD heads 320 between applications can also be very expensive, particularly when using LEDs, because the purged fluid material may become contaminated and unusable. This embodiment is also useful for enabling the deposited fluid materials to sufficiently cure between the different applications, thereby preventing the different fluid materials from mixing and losing their desired and identifiably unique characteristics. Suitable curing time can generally be provided by delaying the movement of the substrate 350 between the different PMD heads 320.

According to one alternative embodiment, multiple separate PMD systems are used sequentially to deposit the different colored polymers on a single substrate, thereby enabling the fluid material to completely dry between the different applications, and thereby eliminating the need to purge the corresponding PMD heads.

According to yet another embodiment, a single PMD system, can be used to deposit the different colored polymers with a plurality of PMD heads that are each connected with a dedicated fluid material supply systems having the different colored polymer. According to this embodiment, the different PMD heads can be interchangeably connected with the mounting bracket, during use, and the docking stations, during nonuse.

According to yet another embodiment, a single PMD head can be used to deposit a variety of different polymers or fluid materials. According to this embodiment, the PMD head is purged between uses, as generally described above in reference to Figure 13.

Once the fluid material is deposited, it is sometimes desirable to expedite or otherwise control the curing of the fluid material. One method for controlling the cure rate of the fluid material once deposited is to control the temperature of the substrate. For instance, the substrate can be heated while it is mounted on the vacuum chuck by heating the porous plate with a heating element contained within the vacuum chuck. Alternatively, the fluid material can be heated, such as, for example, in the PMD tool.

However, it will be appreciated that different fluid materials can have different properties and curing rates. Accordingly, the PMD systems of the invention can also include a temperature control component configured to control the heating elements contained within the vacuum chuck

If the coefficient of thermal expansion and the temperature to which the substrate is heated is too high, the substrate can expand to the point at which a calibration and alignment process performed on the unheated substrate may not be accurate. One of at least two mechanisms can then be used to compensate for the expansion. First, if the coefficient of thermal expansion is known, the new position of the entire substrate can be determined with the modules of the PMD system based on the original position and the expected expansion or contraction. Second, the alignment systems that have been described herein can be used to recalibrate and realign the substrate after it has been heated. Although either technique can be suitable, the latter is often more accurate, since direct measurement of the position of the substrate is used.

In summary, the invention, as it has been described herein, generally enables precise microdeposition of fluid materials on substrates. Although the previous examples go into some detail regarding the use of polymers applied to substrates in specific color arrangements, it will be appreciated that the invention is not limited to the use of polymers nor to the application of the fluid materials in any particular sequence. Furthermore, although the previous examples may be suitable for manufacturing PLED displays, it should be appreciated that the PMD systems of the invention can also be used to manufacture LEDs, LCDs, CRTs, and other displays requiring the deposition of different fluid materials on a substrate.

In other applications, the PMD processes of the invention can also be used with different fluid materials to manufacture printed circuit board (PCB) structures, including traces, resistors, photo resists, and light guides. The PMD processes can also be used in the biomedical industry when testing bodily, organic, or synthetic fluids, products, or substances. In yet other applications, the PMD systems can be used to deposit controlled quantities of DNA strands, vaccines, medicines, bacteria, viruses, and other biomedical products into pipettes or onto glass plates for research and development, as well as for manufacture.

The present claimed invention may be embodied in other specific forms without departing from its essential characteristics as claimed. The described embodiments are to be considered in all respects only as illustrative, not restrictive. The scope of the invention is, therefore, indicated by the appended claims rather than by the foregoing description. All changes that come within the meaning and range of equivalency of the claims are to be embraced within their scope.

## Claims

1. An apparatus for depositing a fluid manufacturing material on a substrate (38, 350), the apparatus comprising:
a microdeposition head (16, 320) including a nozzle assembly (98) and operable to discharge droplets of the fluid manufacturing material from the nozzle assembly onto the substrate;
a stage (12, 330) configured for securely receiving the substrate and moving the substrate with respect to the microdeposition head;
a head support (18) removably mounting the microdeposition head above the stage; and
a control system in communication with the microdeposition head (16, 320) and the stage (12, 320) to control a pitch of the nozzle assembly relative to the stage and a deposition of the droplets of the fluid manufacturing material discharged from the nozzle assembly on the substrate,
**characterized in that** the control system includes a droplet diagnostic sensor (22) operable to measure characteristics of the droplets discharged from the nozzle assembly,
wherein the characteristics include at least one of shape, size, position, angle of deviation, and speed,
wherein the droplet diagnostic sensor (22) includes a camera (68) that captures a plurality of images of the droplets in flight, and
wherein the microdeposition head is rotatable and the camera captures the plurality of images at a plurality of rotation angles of the microdeposition head.

2. An apparatus as recited in claim 1, wherein the control system includes an alignment sensor (20) operable to identify an alignment of the substrate with respect to the rotatable microdeposition head.

3. An apparatus as recited in claim 1, wherein the control system includes a nozzle control component configured to control the characteristics of the droplets discharged from the nozzle assembly.

4. An apparatus as recited in claim 1, wherein the stage (12, 330) is operable to move the substrate with respect to the rotatable microdeposition head while the microdeposition head deposits the fluid manufacturing material on the substrate.

5. An apparatus as recited in claim 1, wherein the stage (12, 330) is operable to move the substrate in at least one horizontal direction and at least one vertical direction with respect to the rotatable microdeposition head.

6. An apparatus as recited in claim 1, wherein the head support (18) includes a turret (72) operable to rotate the rotatable microdeposition head with respect to the stage.

7. An apparatus as recited in claim 1, further comprising a fluid manufacturing material supply system (102, 150) in fluid communication with the microdeposition head and operable to supply the fluid manufacturing material to the rotatable microdeposition head.

8. An apparatus as recited in claim 1, wherein the head support (18) is mounted to a stationary gantry.

9. An apparatus as recited in claim 1, wherein the head support (18) is mounted to a linear bearing assembly (210) connected to a support beam (220).

10. An apparatus as recited in claim 1, wherein the rotatable microdeposition head is a plurality of rotatable microdeposition heads and the head support is a plurality of corresponding head supports operable to removably secure the plurality of rotatable microdeposition heads.

11. An apparatus as recited in claim 1, wherein the rotatable microdeposition head discharges droplets approximating a volume of about 10 picoliters.

12. An apparatus as recited in claim 1, wherein the control system controls a relative position of the rotatable microdeposition head and the substrate to form microstructures on the substrate with the droplets, generates firing waveforms that discharge droplets from the nozzle assembly, and accelerates or delays timing of the firing waveforms based on the angle of deviation.

13. An apparatus as recited in claim 12, wherein the nozzle assembly (98) nominally ejects the droplets in a first direction and wherein the angle of deviation is relative to the first direction.

14. An apparatus as recited in claim 13, wherein the first direction is substantially vertical, wherein the control system determines a horizontal displacement of a droplet relative to a center of the nozzle assembly and a vertical distance of the droplet from the nozzle assembly based on an image of the plurality of images, and wherein the control system determines the angle of deviation based on the horizontal displacement and the vertical distance.

15. An apparatus as recited in claim 14, wherein the control system initiates maintenance on the nozzle assembly when the angle of deviation is greater than a predetermined amount.

16. An apparatus as recited in claim 12, wherein the nozzle assembly includes a plurality of nozzles, wherein the camera captures one of the plurality of images corresponding to each of the plurality of nozzles, wherein the control system determines the angle of deviation for each of the plurality of nozzles based on the corresponding one of the plurality of images, and wherein the control system accelerates or delays timing of the firing waveforms individually for each of the plurality of nozzles based on the corresponding angle of deviation.

17. An apparatus as recited in claim 12, wherein the control system determines a three-dimensional droplet shape based on at least two of the plurality of images, and wherein the control system calculates a droplet volume based on the three-dimensional droplet shape.

18. An apparatus as recited in claim 17, wherein the control system iteratively calculates the droplet volume and adjusts the firing waveforms until the droplet volume is approximately equal to a predetermined value.

19. An apparatus as recited in claim 1, wherein the nozzle assembly nominally ejects the droplets in a first direction, and wherein the camera is pointed in a second direction generally transverse to the first direction.

20. An apparatus as recited in claim 19, wherein the camera (68) captures the plurality of images at first and second rotation angles of the rotatable microdeposition head, wherein the first and second rotation angles are separated by approximately 90 degrees.

21. An apparatus as recited in claim 20, wherein the rotatable microdeposition head is rotated between the first and second rotation angles between successive every pair of the plurality of images.

22. An apparatus as recited in claim 1, further comprising a strobe (69) that fires as the camera (68) takes each of the plurality of images.

## Patentansprüche

1. Vorrichtung zum Ablagern eines fluiden Herstellungsmaterials auf einem Substrat (38, 350), wobei die Vorrichtung umfasst:
einen Mikroablagerungskopf (16, 320), der eine Düsenanordnung (98) umfasst und betreibbar ist, um Tröpfchen des fluiden Herstellungsmaterials von der Düsenanordnung auf das Substrat abzugeben;
eine Plattform (12, 330), die konfiguriert ist, um das Substrat sicher aufzunehmen und das Substrat in Bezug auf den Mikroablagerungskopf zu bewegen;
einen Kopfträger (18), der den Mikroablagerungskopf abnehmbar oberhalb der Plattform hält; und
ein Steuersystem in Kommunikation mit dem Mikroablagerungskopf (16, 320) und der Plattform (12, 320), um ein Abstandmaß der Düsenanordnung relativ zu der Plattform und eine Ablagerung der Tröpfchen des fluiden Herstellungsmaterials, das von der Düsenanordnung auf das Substrat abgegeben wird, zu steuern,
**dadurch gekennzeichnet, dass** das Steuersystem einen Tröpfchendiagnosesensor (22) aufweist, der betrieben werden kann, um Eigenschaften der Tröspfchen zu messen, die von der Düsenanordnung abgegeben werden,
wobei die Eigenschaften zumindest eine von Form, Größe, Position, Abweichungswinkel und Geschwindigkeit umfassen,
wobei der Tröpfchendiagnosesensor (22) eine Kamera (68) aufweist, die eine Vielzahl von Bildern der Tröpfchen im Flug aufnimmt, und
wobei der Mikroablagerungskopf drehbar ist und die Kamera die Vielzahl an Bildern an einer Vielzahl von Drehwinkeln des Mikroablagerungskopf aufnimmt.

2. Vorrichtung nach Anspruch 1, **dadurch gekennzeichnet, dass** das Steuersystem einen Ausrichtsensor (20) aufweist, der betrieben werden kann, um eine Ausrichtung des Substrats in Bezug auf den drehbaren Mikroablagerungskopf zu identifizieren.

3. Vorrichtung nach Anspruch 1, **dadurch gekennzeichnet, dass** das Steuersystem eine Düsensteuerkomponente aufweist, die konfiguriert ist, um die Eigenschaften der von der Düsenanordnung abgegebenen Tröpfchen zu steuern.

4. Vorrichtung nach Anspruch 1, **dadurch gekennzeichnet, dass** die Plattform (12, 330) betrieben werden kann, um das Substrat in Bezug auf den drehbaren Mikroablagerungskopf zu bewegen, während der Mikroablagerungskopf das fluide Herstellungsmaterial auf das Substrat ablagert.

5. Vorrichtung nach Anspruch 1, **dadurch gekennzeichnet, dass** die Plattform (12, 330) betrieben werden kann, um das Substrat in zumindest einer horizontalen Richtung und zumindest einer vertikalen Richtung in Bezug auf den drehbaren Mikzoablagerungskopf zu bewegen.

6. Vorrichtung nach Anspruch 1, **dadurch gekennzeichnet, dass** der Kopfträger (18) einen Revolverkopf (72) umfasst, der betrieben werden kann, um den drehbaren Mikroablagerungskopf in Bezug auf die Plattform zu drehen.

7. Vorrichtung nach Anspruch 1, weiter umfassend ein System zur Zuführung von fluiden Herstellungsmaterial (102, 150) in Fluidverbindung mit dem Mikroablagerungskopf, das betrieben werden kann, um das fluide Herstellungsmaterial an den drehbaren Mikroablagerungskopf zu liefern.

8. Vorrichtung nach Anspruch 1, **dadurch gekennzeichnet, dass** der Kopfträger (18) auf einem ortsfesten Gerüst angebracht ist.

9. Vorrichtung nach Anspruch 1, **dadurch gekennzeichnet, dass** der Kopfträger (18) auf einer linearen Lageranordnung (210) angebracht ist, die mit einem Stützträger (220) verbunden ist.

10. Vorrichtung nach Anspruch 1, **dadurch gekennzeichnet, dass** der drehbare Mikroablagerungskopf eine Vielzahl von drehbaren Mikroablagerungsköpfen darstellt und der Kopfträger eine Vielzahl von entsprechenden Kopfträgern darstellt, die betrieben werden könnten, um die Vielzahl von drehbaren Mikroablagerungsköpfen abnehmbar zu halten.

11. Vorrichtung nach Anspruch 1, **dadurch gekennzeichnet, dass** der drehbare Mikroablagerungskopf Tröpfchen abgibt, die näherungsweise ein Volumen von etwa 10 Picoliter enthalten.

12. Vorrichtung nach Anspruch 1, **dadurch gekennzeichnet, dass** das Steuersystem eine relative Position des drehbaren Mikroablagerungskopfs und des Substrats steuert, um Mikrostrukturen auf dem Substrat mit den Tröpfchen auszubilden, Abschuss-Wellenformen erzeugt, die Tröpfchen von der Düsenanordnung abgeben, und die zeitliche Abfolge der Abschuss- Wellenformen auf der Grundlage des Abweichungswinkels beschleunigt oder verzögern.

13. Vorrichtung nach Anspruch 12, **dadurch gekennzeichnet, dass** die Düsenanordnung (98) die Tröpfchen nominal in einer ersten Richtung ausstößt, wobei der Abweichungswinkel relativ zu der ersten Richtung ist.

14. Vorrichtung nach Anspruch 13, **dadurch gekennzeichnet, dass** die erste Richtung im Wesentlichen vertikal ist, wobei das Steuersystem eine horizontale Verlagerung eines Tröpfchens relativ zu einem Mittelpunkt der Düsenanordnung und einen vertikalen Abstand des Tröpfchens von der Düsenanordnung auf der Grundlage eines Bilds aus der Vielzahl von Bildern bestimmt, und wobei das Steuersystem den Abweichungswinkel auf der Grundlage der horizontalen Verlagerung und des vertikalen Abstands bestimmt.

15. Vorrichtung nach Anspruch 14, **dadurch gekennzeichnet, dass** das Steuersystem eine Wartung der Düsenanordnung auslöst, wenn der Abweichungswinkel größer als ein vorbestimmter Betrag ist.

16. Vorrichtung nach Anspruch 12, **dadurch gekennzeichnet, dass** die Düsenanordnung eine Vielzahl von Düsen umfasst, wobei die Kamera eine der Vielzahl von Bildern entsprechend jeder einzelnen aus der Vielzahl von Düsen aufnimmt, wobei das Steuersystem den Abweichungswinkel für jede aus der Vielzahl von Düsen auf der Grundlage eines entsprechenden Bilds aus der Vielzahl von Bildern bestimmt, und wobei das Steuersystem die zeitliche Abfolge der Abschuss-Wellenformen individuell für jede aus der Vielzahl von Düsen auf der Grundlage des entsprechenden Abweichungswinkels beschleunigt oder verzögert.

17. Vorrichtung nach Anspruch 12, **dadurch gekennzeichnet, dass** das Steuersystem eine dreidimensionale Tröpfchenform auf der Grundlage von zumindest zwei Bildern aus der Vielzahl von Bildern bestimmt, und wobei das Steuersystem ein Tropfehenvolumen auf der Grundlage der dreidimensionalen Tröpfchenform berechnet.

18. Vorrichtung nach Anspruch 17, **dadurch gekennzeichnet, dass** das Steuersystem das Tröpfchenvolumen iterativ berechnet und die Abschuss-Wellenformen anpasst, bis das Tröpfchenvolumen näherungsweise gleich einem vorbestimmten Wert ist.

19. Vorrichtung nach Anspruch 1, **dadurch gekennzeichnet, dass** die Düsenanordnung die Tröpfchen nominal in einer ersten Richtung aufstößt, und wobei die Kamera in einer zweiten Richtung zeigt, die im Wesentlichen quer zu der ersten Richtung ist.

20. Vorrichtung nach Anspruch 19, **dadurch gekennzeichnet, dass** die Kamera (68) die Vielzahl von Bildern an ersten und zweiten Drehwinkeln des drehbaren Mikroablagerungskopfs aufnimmt, wobei die ersten und zweiten Drehwinkel um etwa 90° voneinander getrennt sind.

21. Vorrichtung nach Anspruch 20, **dadurch gekennzeichnet, dass** der drehbare Mikroablagerungskopf zwischen den ersten und zweiten Drehwinkeln zwischen jedem aufeinanderfolgenden Paar aus der Vielzahl von Bildern gedreht wird.

22. Vorrichtung nach Anspruch 1, weiter umfassend ein Stroboskop (69), das ausgelöst wird, wenn die Kamera (68) jedes aus der Vielzahl von Bildern aufnimmt.

## Revendications

1. Appareil de dépôt d'un matériau de fabrication de fluide sur un substrat (38, 350), l'appareil comprenant :
une tête de micro-dépôt (16, 320) comprenant un ensemble de buse (98) et pouvant être actionnée pour décharger les gouttelettes du matériau de fabrication de fluide à partir de l'ensemble de buse sur le substrat ;
un étage (12, 330), configuré pour recevoir fixement le substrat et déplacer le substrat relativement à la tête de micro-dépôt ;
un support de tête (18) permettant le montage de manière amovible de la tête de micro-dépôt au-dessus de l'étage ; et
un système de contrôle en communication avec la tête de micro-dépôt (16, 320) et l'étage (12, 320), permettant de contrôler l'écartement de l'ensemble de buse relativement à l'étage et le dépôt des gouttelettes du matériau de fabrication de fluide déchargé de l'ensemble de buse sur le substrat,
**caractérisé en ce que** le système de contrôle comprend un capteur de diagnostic de gouttelettes (22), pouvant être actionné pour mesurer les caractéristiques des gouttelettes déchargées de l'ensemble de buse,
dans lequel les caractéristiques comprennent au moins un élément parmi la forme, la taille, la position, l'angle de déviation, et la vitesse,
dans lequel le capteur de diagnostic de gouttelettes (22) comprend une caméra (68) qui capture une pluralité d'images des gouttelettes en vol, et
dans lequel la tête de micro-dépôt est rotative et la caméra capture la pluralité d'images à une pluralité d'angles de rotation de la tête de micro-dépôt.

2. Appareil selon la revendication 1, dans lequel le système de contrôle comprend un capteur d'alignement (20) pouvant être actionné pour identifier un alignement du substrat relativement à la tête de micro-dépôt rotative.

3. Appareil selon la revendication 1, dans lequel le système de contrôle comprend un composant de contrôle de buse, configuré pour contrôler les caractéristiques des gouttelettes déchargées de l'ensemble de buse.

4. Appareil selon la revendication 1, dans lequel l'étage (12, 330) peut être actionné pour déplacer le substrat relativement à la tête de micro-dépôt rotative tandis que la tête de micro-dépôt dépose le matériau de fabrication de fluide sur le substrat.

5. Appareil selon la revendication 1, dans lequel l'étage (12, 330) peut être actionné de façon à déplacer le substrat dans au moins une direction horizontale et au moins une direction verticale relativement à la tête de micro-dépôt rotative.

6. Appareil selon la revendication 1, dans lequel le support de tête (18) comprend une tourelle (72) pouvant être actionnée pour tourner la tête de micro-dépôt rotative relativement à l'étage.

7. Appareil selon la revendication 1, comprenant en outre un système d'alimentation de matériau de fabrication de fluide (102, 150) en communication fluidique avec la tête de micro-dépôt et pouvant être actionné pour amener le matériau de fabrication de fluide à la tête de micro-dépôt rotative.

8. Appareil selon la revendication 1, dans lequel le support de tête (18) est monté sur un portique fixe.

9. Appareil selon la revendication 1, dans lequel le support de tête (18) est monté sur un ensemble de support linéaire (210) raccordé à une traverse de support (220).

10. Appareil selon la revendication 1, dans lequel la tête de micro-dépôt rotative est constituée d'une pluralité de têtes de micro-dépôt rotatives et le support de tête est constituée d'une pluralité de supports de tête correspondants pouvant être actionnés pour fixer de manière amovible la pluralité de têtes de micro-dépôt rotatives.

11. Appareil selon la revendication 1, dans lequel la tête de micro-dépôt rotative décharge des gouttelettes ayant un volume approximatif d'environ 10 picolitres.

12. Appareil selon la revendication 1, dans lequel le système de contrôle contrôle une position relative de la tête de micro-dépôt rotative et le substrat pour former des microstructures sur le substrat avec des gouttelettes, génère des formes d'onde d'allumage qui déchargent les gouttelettes de l'ensemble de buse, et accélère ou retarde le timing des formes d'onde d'allumage, sur la base de l'angle de déviation.

13. Appareil selon la revendication 12, dans lequel l'ensemble de buse (98) éjecte de manière nominale les gouttelettes dans une première direction et dans lequel l'angle de déviation est relatif à la première direction.

14. Appareil selon la revendication 13, dans lequel la première direction est sensiblement verticale, dans lequel le système de contrôle détermine un déplacement horizontal d'une gouttelette par rapport à un centre de l'ensemble de buse et une distance verticale de la gouttelette par rapport à l'ensemble de buse, sur la base d'une image de la pluralité d'images, et dans lequel le système de contrôle détermine l'angle de déviation sur la base du déplacement horizontal et de la distance verticale.

15. Appareil selon la revendication 14, dans lequel le système de contrôle débute la maintenance sur l'ensemble de buse quand l'angle de déviation est supérieur à une valeur prédéterminée.

16. Appareil selon la revendication 12, dans lequel l'ensemble de buse comprend une pluralité de buses, dans lequel la caméra capture une parmi la pluralité d'images correspondant à chacune de la pluralité des buses, dans lequel le système de contrôle détermine l'angle de déviation pour chacune parmi la pluralité de buses, sur la base de l'image correspondante parmi la pluralité d'images, et dans lequel le système de contrôle accélère ou retarde le timing des formes d'onde d'allumage individuellement pour chacune de la pluralité des buses, sur la base de l'angle de déviation correspondant.

17. Appareil selon la revendication 12, dans lequel le système de contrôle détermine une forme de gouttelette en trois dimensions, sur la base d'au moins deux parmi la pluralité d'images, et dans lequel le système de contrôle calcule un volume de gouttelette, sur la base de la forme de gouttelette en trois dimensions.

18. Appareil selon la revendication 17, dans lequel le système de contrôle calcule de manière itérative le volume des gouttelettes et ajuste les formes d'onde d'allumage jusqu'à ce que le volume des gouttelettes soit approximativement égal à une valeur prédéterminée.

19. Appareil selon la revendication 1, dans lequel l'ensemble de buse éjecte de manière nominale les gouttelettes dans une première direction, et dans lequel la caméra est pointée dans une seconde direction, généralement transversale à la première direction.

20. Appareil selon la revendication 19, dans lequel la caméra (68) capture la pluralité d'images aux premier et second angles de rotation de la tête de micro-dépôt rotative, dans lequel le premier et le second angles de rotation sont séparés d'approximativement 90 degrés.

21. Appareil selon la revendication 20, dans lequel la tête de micro-dépôt rotative est tournée entre le premier et le second angles de rotation entre chaque paire successive de la pluralité d'images.

22. Appareil selon la revendication 1, comprenant en outre un tube stroboscopique (69) qui s'allume quand la caméra (68) prend chacune de la pluralité d'images.
